# EUROPEAN PATENT SPECIFICATION

(11) **EP 2 590 260 B1**
(45) Date of publication and mention of the grant of the patent: **16.07.2014**
(21) Application number: 13153273.1
(22) Date of filing: 08.05.2009
(51) Int. Cl.: H01Q 1/38, G06K 19/07, G06K 19/077, H01Q 1/50, H01Q 7/00, H05K 1/02

(54) **Wireless IC device**
Drahtlose integrierte Schaltung
Dispositif CI sans fil

(30) Priority: 21.05.2008 JP 2008133335; 18.09.2008 JP 2008239826
(43) Date of publication of application: 08.05.2013
(62) Divisional of application: 09750476.5
(73) Proprietor: MURATA MANUFACTURING CO., LTD., Nagaokakyo-shi, Kyoto 617-8555 (JP)
(72) Inventor: Kato, Noboru, Nagaokakyo-shi Kyoto 617-8555 (JP); Ikemoto, Nobuo, Nagaokakyo-shi Kyoto 617-8555 (JP)
(74) Representative: Zimmermann, Tankred Klaus

(56) References cited:
- WO-A1-2007/138857
- JP-A- 2006 203 852
- US-A1- 2006 044 769

## Description

### Technical Field

The present invention relates to wireless integrated circuit (IC) devices including wireless ICs and radiation plates. More particularly, the present invention relates to a wireless IC device used in a radio frequency identification (RFID) system.

### Background Art

RFID systems have been developed as article management systems in recent years. In such a RFID system, a reader-writer generating an induced magnetic field communicates with an IC tag (hereinafter referred to as a wireless IC device) that is added to an article and that stores certain information by a non-contact method using the electromagnetic field to transfer certain information.

The wireless IC device used in the RFID system includes a wireless IC chip processing a certain radio signal and a radiation plate transmitting and receiving the radio signal. For example, a wireless IC device described in Patent Document 1 is known.

The wireless IC device described in Patent Document 1 includes a wireless IC chip, a power-supply circuit board on which the wireless IC chip is mounted and which includes a power supply circuit including a resonant circuit having a given resonant frequency, and a radiation plate which is adhered to the bottom face of the power-supply circuit board and which radiates a transmission signal supplied from the power supply circuit and receives a reception signal to supply the received reception signal to the power supply circuit. The resonant frequency of the resonant circuit in the power-supply circuit board is designed so as to substantially correspond to the frequency of the transmission and reception signals, so that the wireless IC device has very stable frequency characteristics.

Since the frequency of the radio signal transmitted and received by the radiation plate is substantially determined by the power supply circuit in the power-supply circuit board in the wireless IC device described in Patent Document 1, the wireless IC device has a very excellent characteristic in that the frequency of the radio signal hardly depends on the size and/or shape of the radiation plate. However, for example, as described in Paragraph 0020 in Patent Document 1, the magnitude of the gain of the radio signal depends on the size and/or shape of the radiation plate. In other words, the gain is varied depending on the varied size and/or shape of the radiation plate. However, means for controlling the gain is not sufficiently disclosed in Patent Document 1.

Patent Document 1: International publication No. 2007/083574 pamphlet.
WO 2007/138857 A1 discloses a radio frequency IC device comprising a radio frequency IC chip, a feed circuit board mounted with the radio frequency IC chip and having a feed circuit including inductance elements, and a radiation plate electromagnetically coupled to the inductance elements of the feed circuit. The IC chip and the feed circuit board are arranged within the inner circumference of a conductor loop formed by the radiation plate. Claim 1 is delimited against this document.

JP 2006 203852 A discloses a noncontact IC module having a noncontact communicator which has an on-chip antenna connected electrically to an IC chip. A booster antenna comprising a recess is provided, and the noncontact communication body is arranged so as not to come into contact with the buster antenna in the recess.

US 2006/0447769 A1 discloses an RFID device including a transponder chip, a coupling loop disposed on an interposer and an antenna. The antenna comprises a conductor loop and the interposer is arranged within an inner circumference of the conductor loop.

In order to resolve the above problems, it is an object of the present invention to provide a wireless IC device capable of controlling the gain of transmission and reception signals.

This object is achieved by a wireless IC device according to claim 1.

### Advantages

According to the wireless IC device according to the present invention, in particular, the radiation plate includes the opening provided in a part thereof and the slit linking to the opening and, viewed in plan from the direction of the winding axis of the coil pattern in the power-supply circuit board, the opening in the radiation plate is overlapped with at least part of an inner area of the coil pattern. According, when a current flows through the coil pattern, a magnetic field that is excited is ideally distributed through the opening in the coil pattern. The induced magnetic field excites an induced current around the opening in the radiation plate and a difference in voltage is applied to the induced current in the slit. Accordingly, the amount and/or distribution of the induced current can be controlled with the length and/or width of the slit to control the amounts of the electric field and the magnetic field occurring over the radiation plate, thus allowing the gain of the transmission and reception signals to be controlled.

### Brief Description of Drawings

[Fig. 1] Fig. 1 includes diagrams showing a wireless IC device of a first example: Fig. 1(A) is a perspective view of the entire device, Fig. 1(B) is a perspective view showing a state in which a wireless IC chip is mounted on a power-supply circuit board, and Fig. (C) is a perspective view showing a state in which the power-supply circuit board is mounted on a radiation plate.
[Fig. 2] Fig. 2 is a plan view showing the wireless IC device of the first example.
[Fig. 3] Fig. 3 is a schematic plan view showing the main part of the wireless IC device of the first example.
[Fig. 4] Fig. 4 is a schematic perspective view showing the internal configuration of the power-supply circuit board composing the wireless IC device of the first example.
[Fig. 5] Fig. 5 includes diagrams showing the principle of the operation of the wireless IC device of the first example: Fig. 5(A) is a cross-sectional view, Fig. (B) is a plan view around an opening, and Fig. 5(C) is a plan view showing propagation to the radiation plate.
[Fig. 6] Fig. 6 is an equivalent circuit of the wireless IC device of the first example.
[Fig. 7] Fig. 7 is a schematic cross-sectional view showing the main part of the wireless IC device of the first example.
[Fig. 8] Fig. 8 includes diagrams showing a wireless IC device of a second example: Fig. 8(A) is a plan view and Fig. 8(B) is an enlarged plan view of a modification of the second example.
[Fig. 9] Fig. 9 is a schematic perspective view showing a modification of a coil pattern provided inside the power-supply circuit board.
[Fig. 10] Fig. 10 is a cross-sectional view showing a wireless IC device of a third example.
[Fig. 11] Fig. 11 is a plan view showing a wireless IC device (the power-supply circuit board is omitted) of a fourth example.
[Fig. 12] Fig. 12 is a plan view showing a wireless IC device (the power-supply circuit board is omitted) of a fifth example.
[Fig. 13] Fig. 13 is a front view showing a state in which the wireless IC device of the fifth example is attached to an article.
[Fig. 14] Fig. 14 is a perspective view showing the main part of a wireless IC device of a sixth example.
[Fig. 15] Fig. 15 is a cross-sectional view showing the wireless IC device of the sixth example.
[Fig. 16] Fig. 16 is a plan view showing a first modification of the radiation plate according to an embodiment.
[Fig. 17] Fig. 17 is a plan view showing a second modification of the radiation plate according to an embodiment.
[Fig. 18] Fig. 18 is a plan view showing a third modification of the radiation plate according to an embodiment.
[Fig. 19] Fig. 19 includes diagrams showing a fourth modification of the radiation plate according to an embodiment: Fig. 19(A) is an exploded plan view and Fig. 19(B) is a plan view in a combined state.

Wireless IC devices according to the present invention will herein be described on the basis of specific embodiments. The same reference numerals are used to identify parts and components common to the drawings. A duplicated description of such parts and components is omitted herein.

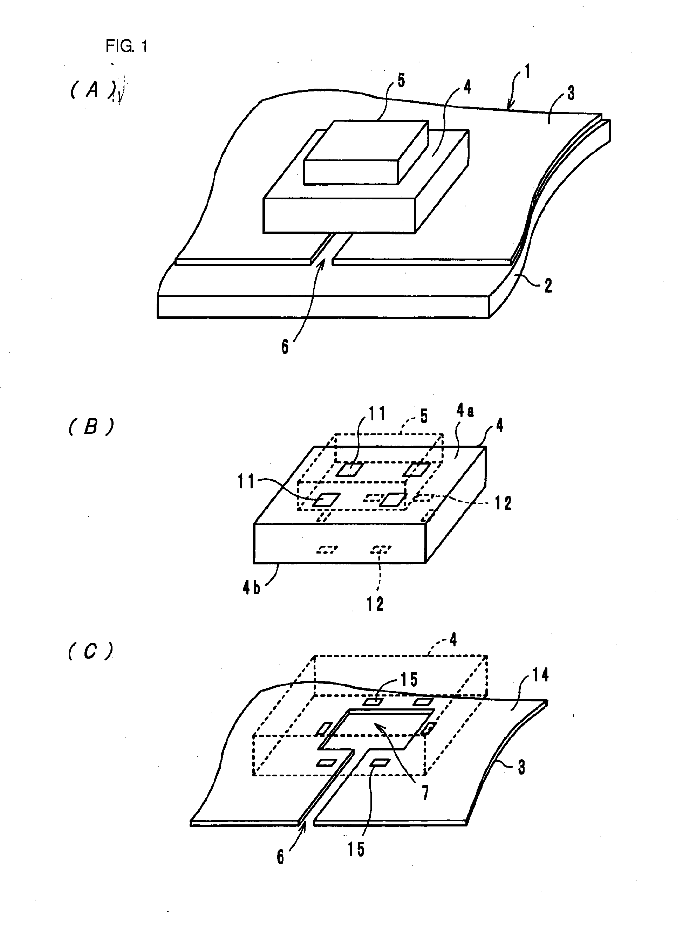

### (First example, refer to Figs. 1 to 7)

The configuration of a wireless IC device of a first example will now be described mainly with reference to Fig. 1. As shown in Fig(A) etc., in a wireless IC device 1, a radiation plate 3 formed of a metallic film such as a metallic foil is provided on a support base 2, which is, for example, a printed circuit board. A power-supply circuit board 4 is mounted on the radiation plate 3. The power-supply circuit board 4 includes a power supply circuit including at least one coil pattern, and a wireless IC chip 5 processing a certain radio signal is installed on the power-supply circuit board 4. Specifically, the wireless IC chip 5 is installed on one main face 4a of the power-supply circuit board 4, and the power-supply circuit board 4 is mounted on the radiation plate 3 with the other main face 4b of the power-supply circuit board 4 as the mounting face. The wireless IC chip 5 includes a clock circuit, a logic circuit, a memory circuit, and so on and necessary information is stored in the wireless IC chip 5.

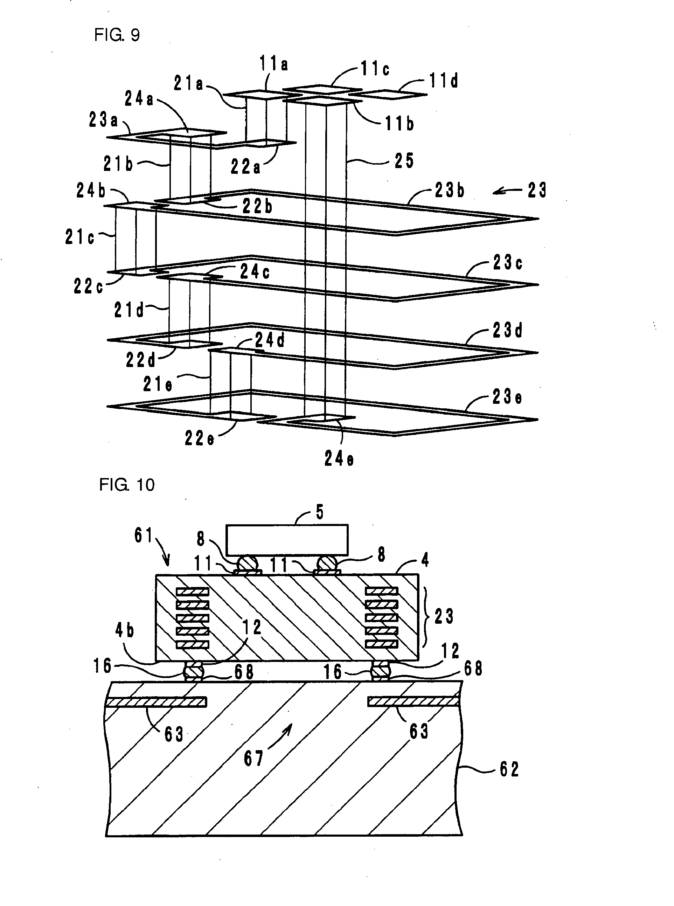

As shown in Fig. 1(B) etc., multiple connection electrodes 11 via which the wireless IC chip 5 is installed on and connected to the power-supply circuit board 4 are provided on the one main face 4a of the power-supply circuit board 4. The connection electrodes 11 are electrically connected to the respective multiple connection electrodes (not shown) provided on the rear face of the wireless IC chip 5 via conductive bonds 8 (refer to Fig. 10) such as solder. As a result, the wireless IC chip 5 is installed on the one main face 4a of the power-supply circuit board 4. In addition, mounting electrodes 12 via which the power-supply circuit board 4 is mounted on the radiation plate 3 are provided on the other main face 4b of the power-supply circuit board 4.

As shown in Fig. 1(C) etc., the radiation plate 3 includes an opening 7 provided in a part thereof and a slit 6 linking to the opening 7. One end of the slit links to the opening 7 and the other end thereof opens at a side edge of the radiation plate 3. In other words, the slit 6 is provided so as to communicate the opening 7 with the side edge of the radiation plate 3. Although the slit 6 advantageously has a straight shape, as in the first example, in terms of the workability, the slit 6 may be formed into a meander shape or a curved shaped.

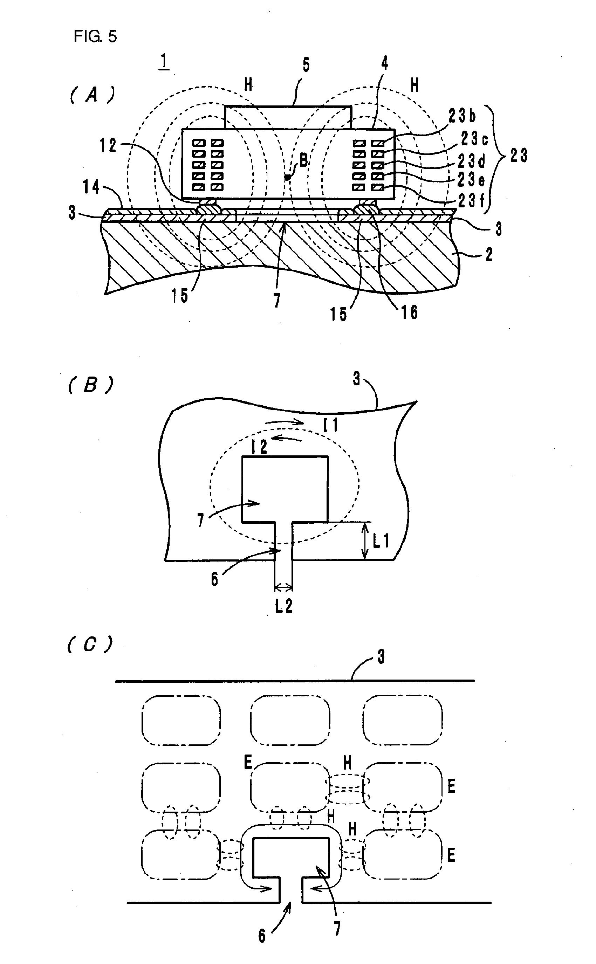

Furthermore, multiple mounting electrodes 15 via which the power-supply circuit board 4 is mounted on and connected to the fringe of the opening 7 are provided on the radiation plate 3. The mounting electrodes 15 are connected to the mounting electrodes 12 provided on the other main face 4b of the power-supply circuit board 4 via conductive bonds 16 such as solder (refer to Fig. 5). The mounting electrodes 15 are composed of apertures resulting from partially striping a protective layer 14 that is coated on the surface of the radiation plate 3 and that is made of a resist material or the like. In other words, part of the radiation plate 3, which corresponds to the open parts in the protective layer 14, is formed as the mounting electrodes 15.

In the first example, the mounting electrodes 12 provided on the other main face 4b of the power-supply circuit board 4 are not directly connected to the power supply circuit provided inside the power-supply circuit board 4. The mounting electrodes 12 are joined to the mounting electrodes 15 formed as part of the radiation plate 3 via the conductive bonds 16 such as solder.

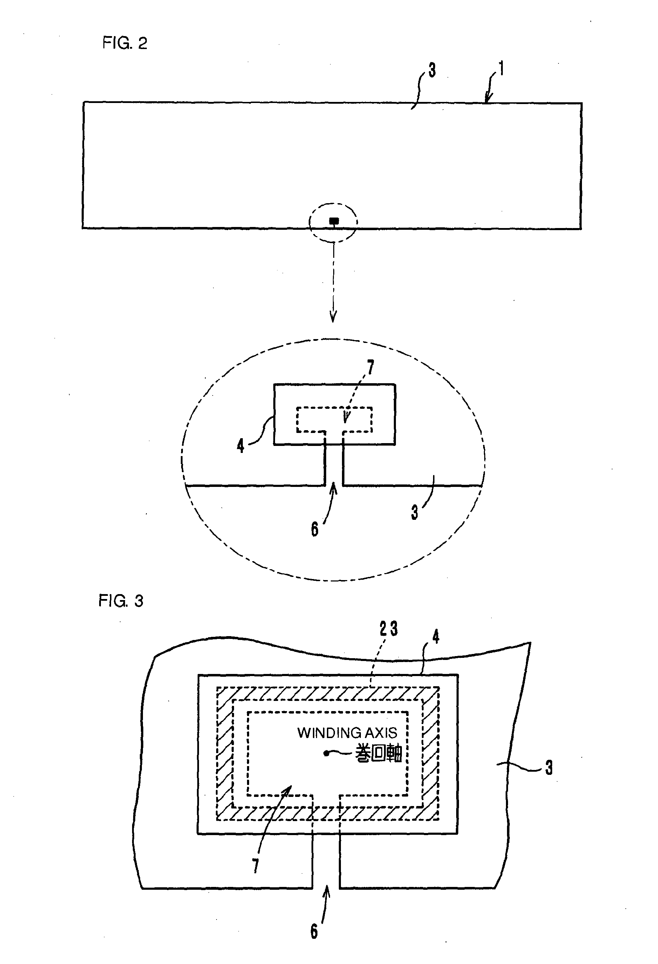

The radiation plate 3 has a planar rectangular shape, as shown in Fig. 2, and the power-supply circuit board 4 on which the wireless IC chip 5 is mounted is installed at a substantially central part near one longitudinal side edge. In the first example, for example, a ground electrode that is incorporated in an electronic device, such as a mobile phone or a personal computer, and that is provided on a printed circuit board composing a certain electronic circuit may be used as the radiation plate 3. In other words, although the radiation plate 3 may be provided as an element only having a radiation function, ground electrodes used in various electronic circuits may be used as the radiation plate 3, instead of such an element.

In terms of the relationship with a coil pattern 23 (refer to Fig. 3) provided in the power-supply circuit board 4, the opening 7 provided in the radiation plate 3 is overlapped with at least part of an inner area of the winding path of the coil pattern 23, viewed in plan from the direction of the winding axis of the coil pattern 23. As shown in Fig. 3, it is preferred that the opening 7 be substantially entirely overlapped with the inner area of the coil pattern 23 and the opening 7 have approximately the same area as that of the inner area of the coil pattern 23. This is because magnetic fields H (refer to Fig. 5(A)) caused by the coil pattern 23 efficiently spread over the radiation plate 3 to suppress the loss and to improve the gain.

The power-supply circuit board 4 in the first example is composed as a multilayer body in which multiple dielectric layers formed of resin layers or ceramic layers are layered. The coil pattern 23 composing the power supply circuit results from connecting multiple annular electrodes arranged on the respective multiple dielectric layers via interlayer conductors in the layered direction in a helical pattern having the winding axis. However, the power-supply circuit board may have a coil pattern provided on a single-layer board.

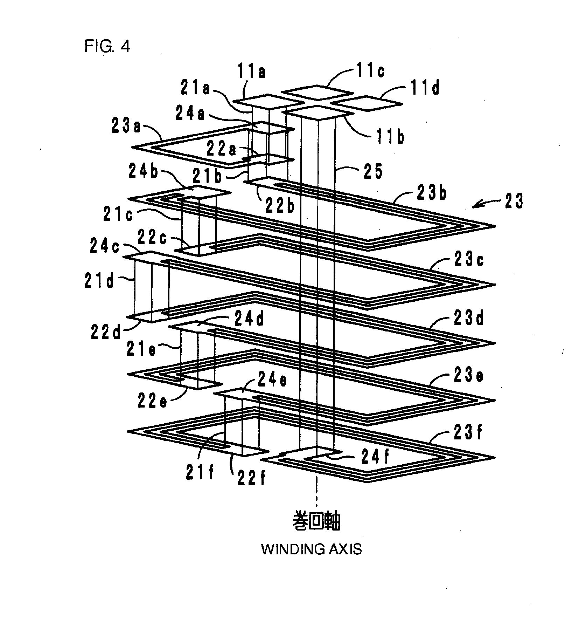

Specifically, as shown in Fig. 4, in the power-supply circuit board 4 including the helical coil pattern 23, the power supply circuit including the coil pattern 23 supplies a transmission signal from the wireless IC chip 5 to the radiation plate 3 and supplies a reception signal (reception power) from the radiation plate 3 to the wireless IC chip 5.

The power supply circuit will now be specifically described. A connection electrode 11a toward the power-supply circuit board 4 connected to the connection electrode on the wireless IC chip 5 is connected to a pad conductor 22a provided on another layer via an interlayer connection conductor 21a provided in the multilayer body, and a wiring conductor 23a that extends from the pad conductor 22a and that composes part of the coil pattern 23 on the corresponding layer is routed in an annular shape to be connected to a pad conductor 24a provided on the same layer. The pad conductor 24a is connected to a pad conductor 22b provided on another layer via an interlayer connection conductor 21b, and a wiring conductor 23b that extends from the pad conductor 22b and that composes part of the coil pattern 23 on the corresponding layer is routed in an annular pattern to be connected to a pad conductor 24b provided on the same layer.

Furthermore, the pad conductor 24b is connected to a pad conductor 22c provided on another layer via an interlayer connection conductor 21c, and a wiring conductor 23c that extends from the pad conductor 22c and that composes part of the coil pattern 23 on the corresponding layer is routed in an annular pattern to be connected to a pad conductor 24c provided on the same layer. The pad conductor 24c is connected to a pad conductor 22d provided on another layer via an interlayer connection conductor 21d, and a wiring conductor 23d that extends from the pad conductor 22d and that composes part of the coil pattern 23 on the corresponding layer is routed in an annular pattern to be connected to a pad conductor 24d provided on the same layer.

Furthermore, the pad conductor 24d is connected to a pad conductor 22e provided on another layer via an interlayer connection conductor 21e, and a wiring conductor 23e that extends from the pad conductor 22e and that composes part of the coil pattern 23 on the corresponding layer is routed in an annular pattern to be connected to a pad conductor 24e provided on the same layer. The pad conductor 24e is connected to a pad conductor 22f provided on another layer via an interlayer connection conductor 21f, and a wiring conductor 23f that extends from the pad conductor 22f and that composes part of the coil pattern 23 on the corresponding layer is routed in an annular pattern to be connected to a pad conductor 24f provided on the same layer. The pad conductor 24f is connected to a connection electrode 11b toward the power-supply circuit board 4 connected to another connection electrode on the wireless IC chip 5 via an interlayer connection conductor 25.

In other words, the interlayer connection conductors 21a to 21f, the pad conductors 22a to 22f, the annular wiring conductors 23a to 23f, the pad conductors 24a to 24f, and the interlayer connection conductor 25 form the coil pattern 23. Electrodes 11c and 11d are provided on the surface of the multilayer body composing the power-supply circuit board 4. The electrodes 11c and 11d serve as fixing electrodes used in the installation of the wireless IC chip 5 and are not connected to the coil pattern 23 provided in the power-supply circuit board 4.

As described above, in the first example, the radiation plate 3 includes the opening 7 provided in a part thereof and the slit 6 linking to the opening 7. The opening 7 is overlapped with the inner area of the coil pattern 23, viewed in plan from the direction of the winding axis of the coil pattern 23 provided in the power-supply circuit board 4. In addition, the opening 7 has approximately the same area as that of the inner area of the coil pattern 23. Accordingly, as shown in Fig. 5(A), for example, in the transmission of a radio signal, a signal current flows from the wireless IC chip 5 to the coil pattern 23 and the induced magnetic fields H caused by the current is ideally distributed through the opening 7, as shown by broken lines in Fig. 5(A). The ideal distribution of the magnetic fields H means that a center B of the two magnetic fields H coincides with the center of the opening 7. The gain of the radiation plate 3 is maximized in this state.

The induced magnetic fields H cause induced currents I1 and I2 (the propagation direction of the current I1 differs from that of the current I2 by 180 degrees) around the opening 7, as shown in Fig. 5(B). Since the slit 6 links to the opening 7, the flows of the induced currents I1 and I2 are restricted by the slit 6 to make a difference in voltage (to produce a capacitance). Accordingly, the amounts and/or distributions of the induced currents I1 and I2 can be controlled with a length L1 and/or a width L2 of the slit 6 to control the amounts of the electric field and the magnetic field caused over the radiation plate 3. As a result, it is possible to control the gain of the transmission signal.

In the above manner, in the radiation plate 3, the distribution of the electromagnetic field is two-dimensionally spread over the radiation plate 3 owing to a linkage among the induction of the magnetic fields H by the induced currents I1 and I2, the induction of an electric field E by the magnetic fields H, and the induction of the magnetic fields H by the electric field E, as shown in Fig. 5(C). The distribution of the electromagnetic field causes the transmission of the radio signal. Accordingly, it is preferred that the radio signal processed in the wireless IC device 1 be within a high frequency band, particularly, within a ultra high frequency (UHF) band.

As described above, the gain of the radio signal transmitted and received on the radiation plate 3 can be controlled with the length L1 and/or the width L2 of the slit 6. Specifically, the gain tends to increase with the increasing length L1 of the slit 6 and with the decreasing width L2 thereof.

As shown in Fig. 5(A), it is preferred that the main parts of the mounting electrodes 12 provided on the power-supply circuit board 4 be provided in areas other than the inner area of the coil pattern 23, viewed in plan from the direction of the winding axis of the coil pattern 23. In other words, it is preferred that the mounting electrodes 12 be arranged so as not to impede the production of the ideal magnetic fields H, particularly, so as not to impede the magnetic fields H passing through the opening 7 and, furthermore, it is preferred that the main parts of the mounting electrodes 12 be provided within the plane of incidence of the coil pattern 23. Because of a similar reason, viewed in plan from the direction of the winding axis of the coil pattern 23, the main parts of the mounting electrodes 15 toward the radiation plate 3 are preferably provided in areas other than the inner area of the coil pattern 23 and, furthermore, the main parts of the mounting electrodes 15 are preferably provided within the plane of incidence of the coil pattern 23.

As shown in Fig. 4 and Fig. 5(A), the annular conductors (the wiring conductors 23b to 23f) provided on the respective dielectric layers are preferably composed of multiple line conductors that are parallel with each other at predetermined intervals. Specifically, in the first example, the annual-shaped wiring conductors 23b to 23f are provided as two line conductors that are parallel with each other and that connects the pad conductors arranged at both sides. Consequently, the magnetic flux passes between the two line conductors to spread the excited magnetic fields toward the center of the coil pattern 23, that is, in the direction orthogonal to the winding axis, thus allowing the magnetic flux to be efficiently used. In addition, an increase in the number of the annular conductors that are parallel with each other has the advantage of decreasing the direct current resistance of the annular conductors. As a result, it is possible to improve the gain of the radio signal.

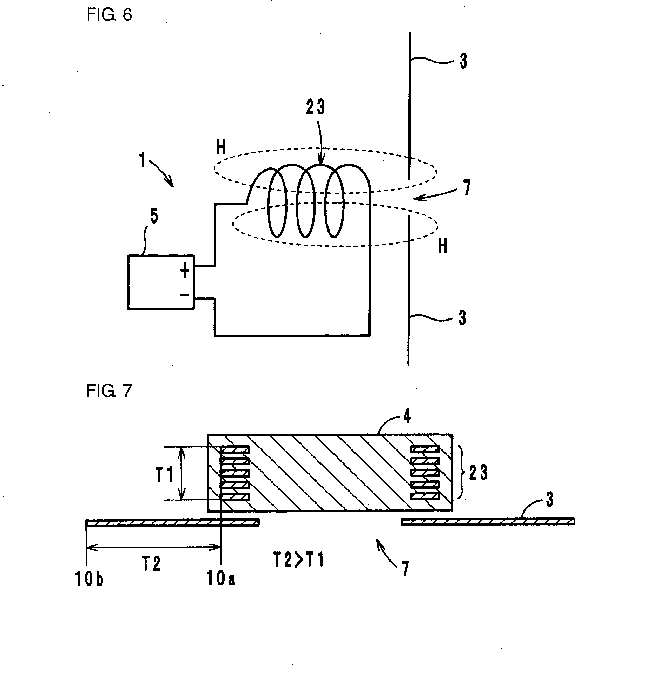

As shown in Fig. 6, the wireless IC device 1 of the first example is provided with the differential-output-type wireless IC chip 5 and has a configuration in which the coil pattern 23 is connected in series between two input-output electrodes. And, the induced magnetic fields H induced by the coil pattern 23 are propagated to the part around the opening 7 through the opening 7 of the radiation plate 3 in an ideal manner.

Although only the coil pattern 23 is shown as the power supply circuit in this equivalent circuit, the stray capacitance produced between the annular electrodes on the respective layers is used as a capacitance component because the inductance of the coil pattern 23 itself is used as an inductance component and the coil pattern 23 is composed of the layered annular electrodes, as described above. It is sufficient for the power supply circuit provided in the power-supply circuit board 4 to have at least the coil pattern. If the power supply circuit has a given resonant frequency, the power supply circuit may further include, for example, a capacitance component and an inductance component for adjusting the resonant frequency.

In the first example, the power supply circuit in the power-supply circuit board 4 preferably has a given resonant frequency and the frequency of the radio signal transmitted and received on the radiation plate 3 preferably substantially corresponds to the resonant frequency. The "substantial correspondence" means that the bandwidth of the resonant frequency of the power supply circuit approximately coincides with the frequency band of the radio signal transmitted and received on the radiation plate 3. Since the frequencies of the transmission signal and/or the reception signal substantially coincide with the resonant frequency of the power supply circuit, as described above, it is possible to provide the wireless IC device having stable frequency characteristics that hardly depend on the size and/or shape of the radiation plate 3 and the shape, the material, etc. of the support base 2 supporting the radiation plate 3.

In the first example, as shown in Fig. 7, in terms of the area of the fringe of the opening 7 in the radiation plate 3, that is, the area of the part where the magnetic flux induced by the coil pattern 23 is received, it is preferred that T2 > T1 where T1 denotes the length of the coil pattern 23 in the direction of the winding axis, that is, the thickness of the coil pattern 23 in the layered direction and T2 denotes the length from a position 10a corresponding to the outer edge of the coil pattern 23 to an outer edge 10b of the radiating plate 3. Establishing such a relationship between the size of the fringe of the opening 7 in the radiation plate 3 and the size of the coil pattern 23 allows the magnetic flux caused by the coil pattern 23 to be received at the side of the radiation plate 3 at a high efficiency of 80% or higher, thus configuring the wireless IC device having a lower loss and a higher gain.

Since the power-supply circuit board 4 is coupled to the radiation plate 3 mainly via the magnetic field in the first example, it is not necessarily consider the impedance matching between the power-supply circuit board 4 and the radiation plate 3. In other words, according to the first example, as described above, preferably designing the shape of the slit 6 allows the gain of the radio signal to be very easily controlled.

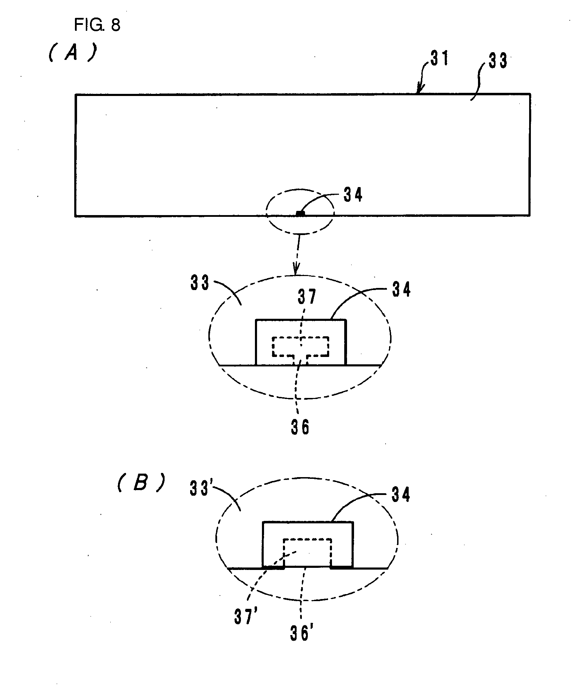

### (Second example, refer to Fig. 8)

As shown in Fig. 8(A), a wireless IC device 31 of a second example is basically configured similarly to the wireless IC device 1 of the first example. The wireless IC device 31 of the second example differs from the wireless IC device 1 of the first example in that a power-supply circuit board 34 is arranged along a side edge of a radiation plate 33. In the wireless IC device 31, the length (refer to reference numeral L1 in Fig. 5(B)) of a slit 36 extending from the side edge of the radiation plate 33 to an opening 37 is decreased and, thus, the gain tends to decrease. In addition, as shown in Fig. 8(B), the width of a slit 36' provided in a radiation plate 33' may be approximately the same as the width of an opening 37'.

Specific numerical values of the gain depending on the numerical value of the length L1 of the slit 36 will now be described when the radiation plate 33 has a length of 14 cm and a width of 4 cm.

When L1 = 0 mm, the gain is equal to -14.4 dB.

When L1 = 0.5 mm, the gain is equal to -13.1 dB.

When L1 = 1.0 mm, the gain is equal to -11.6 dB.

When L1 = 1.5 mm, the gain is equal to -10.9 dB.

When L1 = 2.5 mm, the gain is equal to -9.4 dB.

When L1 = 4.5 mm, the gain is equal to -7.9 dB.

### (Modification of coil pattern, refer to Fig. 9)

In the coil pattern 23 provided in the power-supply circuit board 4, the annual conductor provided on each dielectric layer may be composed of one line conductor, as shown in Fig. 9. The coil pattern 23 shown in Fig. 4 is composed of the wiring conductors 23b to 23f provided on the five layers whereas the coil pattern 23 shown in Fig. 9 is composed of the coil patterns 23b to 23e provided on the four layers.

When each of the annual conductors (the wiring conductors 23b to 23e) provided on the respective dielectric layers is composed of one line conductor, as in this modification, the amount of the two-dimensional distribution of the induced magnetic fields caused by the coil pattern 23 is decreased and, thus, the gain tends to decrease, compared with the configuration shown in Fig. 4. However, the configuration can be simplified and the power-supply circuit board 4 can be reduced in size.

### (Third example, refer to Fig. 10)

A wireless IC device 61 of a third example mainly differs from the wireless IC device 1 of the first example in that a radiation plate 63 is provided inside a support base 62, as shown in Fig. 10. In other words, ground electrodes provided inside the support base (for example, a printed circuit board) 62 are used as the radiation plate 63.

Specifically, as shown in Fig. 10, in the wireless IC device 61, the radiation plate 63 including an opening 67 to which a slit (not shown) links is provided inside the support base 62, which is a printed circuit board. In addition, the power-supply circuit board 4 is mounted on the support base 62. The power-supply circuit board 4 includes a power supply circuit including the coil pattern 23. Furthermore, the wireless IC chip 5 processing a certain radio signal is installed on the surface of the power-supply circuit board 4.

Mounting electrodes 68 for mounting and fixing the power-supply circuit board 4 are provided on the surface of the support base 62. The mounting electrodes 68 are connected to the mounting electrodes 12 provided on the other main face 4b of the power-supply circuit board 4 via the conductive bonds 16 such as solder. In addition, the mounting electrodes 12 toward the power-supply circuit board 4 are not directly connected to the power supply circuit provided inside the power-supply circuit board 4. Similarly, the mounting electrodes 68 toward the support base 62 are not directly connected to the radiation plate 63 provided inside the support base 62.

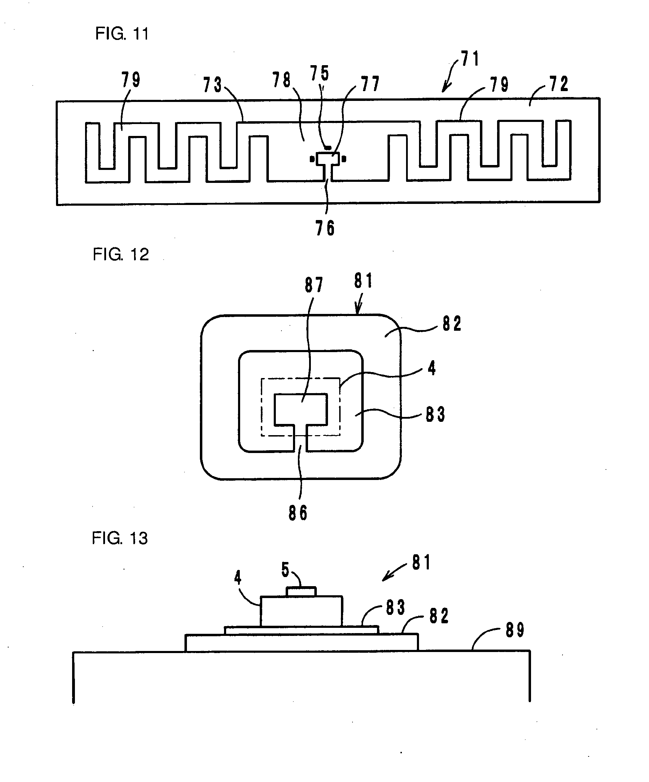

### (Fourth example, refer to Fig. 11)

A wireless IC device 71 of a fourth example is a so-called tag-type (inlay-type) wireless IC device, as shown in Fig. 11. Specifically, the wireless IC device 71 has a configuration in which a radiation plate 73 formed of a flexible metallic film such as a metallic foil is provided on a flexible support 72 such as a polyethylene terephthalate (PET) film. The radiation plate 73 includes a peripheral part of an opening 77 to which a slit 76 links, that is, a planar part 78 where the magnetic flux induced by the coil pattern in the power-supply circuit board is received and meander parts 79 where mainly a radio signal is transmitted and received. However, no clear boundary is provided between the planar part 78 where the magnetic flux is received and the meander parts 79 where the radio signal is transmitted and received. As in the wireless IC device 1 of the first example, mounting electrodes 75 via which the power-supply circuit board is mounted are provided around the opening 77 by partially striping a resist material. The wireless IC device 71 is fixed on various commercial products and can be used for management of distribution histories of the commercial products and so on.

As described above, in the wireless IC devices according to the present invention, the support supporting the radiation plate may be not only the rigid board such as a printed circuit board but also the flexible support 72 such as a PET film, as described in the fourth example. Similarly, the radiation plate itself may be not only the rigid plate such as a sintered metal or a metal plate but also the flexible plate such as a metallic foil. In addition, part of a metal article such as a metallic frame of a pair of glasses or a ring may be used as the radiation plate.

### (Fifth example, refer to Figs. 12 and 13)

In a wireless IC device 81 of a fifth example, a radiation plate 83 formed of a metallic foil or the like is provided on a relatively small support 82 formed of a flexible film or the like, as shown in Fig. 12. The wireless IC device 81 has a patch shape. The radiation plate 83 includes an opening 87 and a slit 86 liking to the opening 87.

As shown in Fig. 13, the wireless IC device 81 is used in a state in which the support 82 is adhered on an article 89. If the support 82 has a certain thickness allowing the passing through of the magnetic flux, the article may be made of metal.

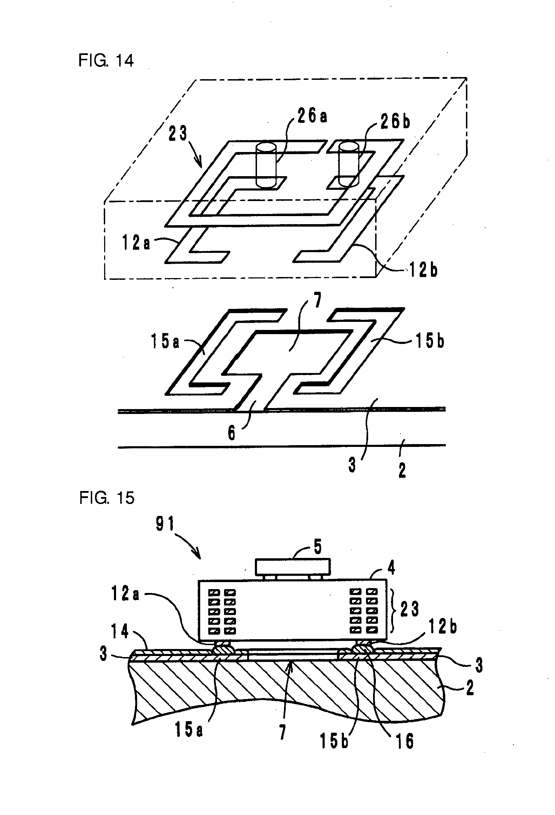

### (Sixth example, refer to Figs. 14 and 15)

In a wireless IC device 91 of a sixth example, mounting electrodes 12a and 12b connected to the coil pattern 23 via interlayer connection conductors 26a and 26b are provided on the rear face of the power-supply circuit board 4 and the mounting electrodes 12a and 12b are connected to mounting electrodes 15a and 15b on the radiation plate 3 via the conductive bonds 16 such as solder, as shown in Figs. 14 and 15. The mounting electrodes 15a and 15b are composed of apertures resulting from partially striping a resist material coated on the surface of the radiation plate 3, as in the mounting electrodes 15 described in the first example. The configuration of the wireless IC device 91 is otherwise the same as that of the first example.

In other words, in the sixth example, not only the coil pattern 23 in the power-supply circuit board 4 is electromagnetically coupled to the radiation plate 3 but also the coil pattern 23 in the power-supply circuit board 4 is directly connected (coupled) to the radiation plate 3. Accordingly, the gain of the radiation plate 3 is increased.

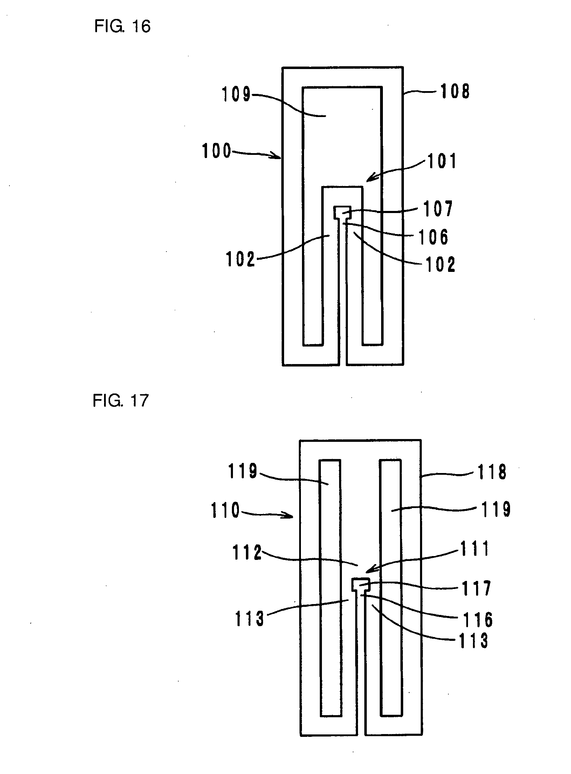

### (First to fourth modifications of radiation plate according to embodiments of the invention, refer to Figs. 16 to 19)

Meanwhile, if multiple wireless IC devices that are uniformly formed and that each include a relatively large radiation plate are laid over one another, the radiation plate blocks the magnetic flux. In such a state, the transmission and reception between the wireless IC devices and a reader-writer is disabled. Accordingly, first to fourth modifications in which the radiation plate includes an aperture so that the magnetic flux can pass through the wireless IC devices even if the multiple wireless IC devices are laid over one another are shown in Figs. 16 to 19. The provision of the apertures (the parts where the magnetic flux passes through) shown in the first to fourth modifications in the radiation plates allows the magnetic flux to pass through the aperture even if the multiple wireless IC devices are laid over one another, thus enabling the transmission and reception with the reader-writer. In addition, the presence of the annular electrodes increases the area of a part where the magnetic flux is received on the radiation plate to improve the gain as an antenna.

A radiation plate 100 of a first modification, shown in Fig. 16, includes a first electrode 101 including an opening 107 over which the power-supply circuit board 4 is mounted and a slit 106, and an annular second electrode 108 surrounding the first electrode 101. The radiation plate 100 is formed of a metallic foil or the like. The first and second electrodes 101 and 108 are integrally provided on one plane and are electrically connected to each other via a connection part 102. In the first modification, the magnetic flux passes through an aperture 109 surrounded by the annular second electrode 108. It is preferred that the opening 107 over which the power-supply circuit board 4 is mounted be positioned at a central part of the annular second electrode 108. This configuration allows the power-supply circuit board 4 to evenly receive the magnetic flux.

A radiation plate 110 of a second modification, shown in Fig. 17, includes a first electrode 111 including an opening 117 over which the power-supply circuit board 4 is mounted and a slit 116, and an annular second electrode 118 surrounding the first electrode 111. The radiation plate 110 is formed of a metallic foil or the like. The first and second electrodes 111 and 118 are integrally provided on one plane and are electrically connected to each other via connection parts 112 and 113. Since the first electrode 111 is connected to the annular second electrode 118 at two positions, as described above, an electrical signal caused by the magnetic field is efficiency transmitted to the power-supply circuit board 4. In the second modification, the magnetic flux passes through apertures 119 surrounded by the annular second electrode 118.

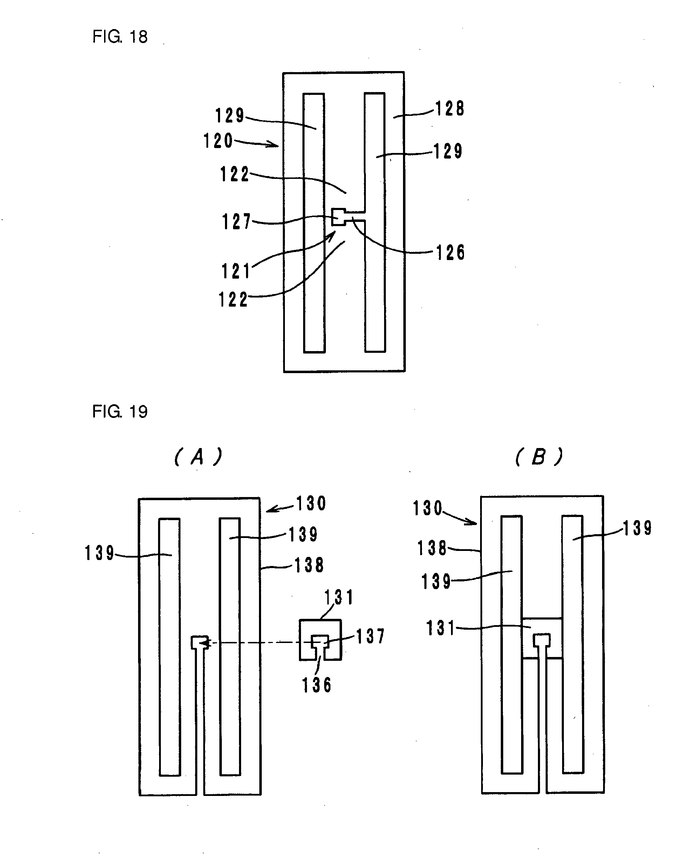

A radiation plate 120 of a third modification, shown in Fig. 18, includes a first electrode 121 including an opening 127 over which the power-supply circuit board 4 is mounted and a slit 126, and an annular second electrode 128 surrounding the first electrode 121. The first and second electrodes 121 and 128 are integrally provided on one plane and are electrically connected to each other via a connection part 122. In the third modification, the magnetic flux passes through apertures 129 surrounded by the annular second electrode 128.

In a radiation plate 130 of a fourth modification, shown in Fig. 19, a first electrode 131 is provided separately from a second electrode 138 and the first electrode 131 is adhered on the second electrode 138. Either of a non-conductive adhesive and a conductive adhesive may be used for the adhesion. In addition, the first electrode 131 may be adhered on the second electrode 138 so that the first electrode 131 opposes the second electrode 138 or so that the film having the first electrode 131 provided on its surface opposes the second electrode 138. The magnetic field is propagated even if the electrode 131 is adhered on the electrode 138. The first electrode 131 includes an opening 137 over which the power-supply circuit board 4 is mounted and a slit 136. The second electrode 138 has the same shape as in the second modification. Also in the fourth modification, the magnetic flux passes through apertures 139 surrounded by the second electrode 138. In the fourth modification, making the opening and the slit in the second electrode 138 larger than the opening 137 and the slit 136 in the first electrode 131 allows the opening 137 of a predetermined size and the width of the slit 136 to be ensured in the first electrode 131 even if a slight positional shift occurs in the adhesion of the first electrode 131 on the second electrode 138.

### (Other embodiments)

The wireless IC devices according to the present invention are not restricted to the above embodiments and may be varied within the scope of the present invention as defined by the appended claims.

### Industrial Applicability

As described above, the present invention is useful for a wireless IC device and, particularly, is excellent in that the gains of transmission and reception signals can be controlled.

- 1, 31, 61, 71, 81, 91: wireless IC device
- 2, 62: support base
- 3, 33, 63, 73, 83, 100, 110, 120, 130: radiation plate
- 4, 34: power-supply circuit board
- 5: wireless IC chip
- 6, 36, 76, 86, 106, 116, 126, 136: slit
- 7, 37, 67, 77, 87, 107, 117, 127, 137: opening
- 72, 82: support
- 101, 111, 121, 131: first electrode
- 108, 118, 128, 138: second electrode

## Claims

1. A wireless integrated circuit device comprising:
a wireless integrated circuit (5) arranged to process a radio signal;
a power-supply circuit board (4) connected to the wireless integrated circuit (5) and including a power supply circuit including at least one coil pattern (23); and
a radiation plate (100; 110; 120; 130) arranged to radiate a transmission signal supplied from the wireless integrated circuit via the power-supply circuit board (4) and to receive a reception signal by the wireless integrated circuit via the power-supply circuit board (4),
wherein the radiation plate (100; 110; 120; 130) includes a first electrode (101; 111; 121; 131) including an opening (107; 117; 127; 137) and an annular second electrode (108; 118; 128; 138) surrounding the first electrode (101; 111; 121; 131), wherein the radiation plate (100; 110; 120; 130) comprises at least one aperture (109; 119; 129; 139) surrounded by the annular second electrode and a slit (106; 116; 126; 136) connected to the opening (107; 117; 127; 137),
wherein the slit (106; 116; 126; 136) extends from the opening to a side edge of the radiation plate (100; 110; 120; 130) or to the at least one aperture (129),
wherein, when viewed in plan from a direction of a winding axis of the coil pattern (23), the opening (107; 117; 127; 137) in the radiation plate (100; 110; 120; 130) overlaps with at least a portion of an inner area of the coil pattern (23), and
wherein, when a current flows through the coil pattern (23), an induced magnetic field excites an induced current around the opening (107; 117; 127; 137) in the radiation plate (100; 110; 120; 130),
**characterized in that** the coil pattern (23) overlaps with at least a portion of the radiation plate (100; 110; 120; 130) surrounding the opening (107; 117; 127; 137).

2. The wireless integrated circuit device according to Claim 1, wherein the aperture (109; 119; 129; 139) comprises first and second portions, wherein the opening (107; 117; 127; 137) is arranged between the first and second portions of the aperture (109; 119; 129; 139).

3. The wireless integrated circuit device according to Claim 2, wherein the slit (106; 116; 136) extends through a region of the radiation plate (100; 110; 130) arranged between the first and second portion of the aperture (109; 119; 139) to an edge of the radiation plate (100; 110; 130).

4. The wireless integrated circuit device according to Claim 1, comprising two apertures (119; 129; 139), wherein the opening (117; 127; 137)is arranged between the apertures (119; 129; 139).

5. The wireless integrated circuit device according to Claim 4, wherein the slit (116; 136) extends through a region of the radiation plate (110; 130) arranged between the apertures (119; 139) to an edge of the radiation plate (110; 130).

6. The wireless integrated circuit device according to Claim 4, wherein the slit (126) extends from the opening (127) to one of the apertures (129).

7. The wireless integrated circuit device according to claim 4 or 5, wherein the radiation plate (130) comprises a third electrode (138), wherein the first electrode (131) is adhered on the third electode (138).

8. The wireless integrated circuit device according to claim 7, wherein an opening and a slit are formed in the third electrode (138) underlying the opening (137) and the slit (136) in the first electrode (131) and, wherein the opening and the slit in the third electrode (138) are larger than opening (137) and the slit (136) in the first electrode (131) .

9. The wireless integrated circuit device according to one of Claims 1 to 8,
wherein, in the radiation of the transmission signal, an induced current is excited around the opening in the radiation plate (100; 110; 120; 130) by a current flowing through the coil pattern (23) and a magnetic field and an electric field caused by the induced current spread over the radiation plate (100; 110; 120; 130) to cause the radiation plate (100; 110; 120; 130) to operate as an electric field antenna.

10. The wireless integrated circuit device according to any of Claims 1 to 9,
wherein, viewed in plan from the direction of the winding axis of the coil pattern (23), the opening in the radiation plate (100; 110; 120; 130) is substantially entirely overlapped with the inner area of the coil pattern (23) and the area of the opening is approximately the same as that of the inner area.

11. The wireless integrated circuit device according to any of Claims 1 to 10,
wherein the wireless integrated circuit (5) is of a chip type and is installed on one main face of the power-supply circuit board (4), and the power-supply circuit board (4) is mounted on the radiation plate (100; 110; 120; 130) or a support base supporting the radiation plate (100; 110; 120; 130) with the other main face of the power-supply circuit board (4) as the mounting face.

12. The wireless integrated circuit device according to Claim 11,
wherein a mounting electrode (12) that is not directly connected to the power supply circuit is provided on the other main face of the power-supply circuit board (4), and the mounting electrode (12) is coupled to a mounting electrode (15) on the radiation plate (100; 110; 120; 130), which is defined as part of the radiation plate or which is not directly connected to the radiation plate (100; 110; 120; 130), via a conductive bond.

13. The wireless integrated circuit device according to Claim 7,
wherein a main part of the mounting electrode (12) on the power-supply circuit board (4) is provided in an area other than the inner area of the coil pattern (23).

14. The wireless integrated circuit device according to any of Claims 1 to 13,
wherein the power-supply circuit board (4) is composed of a multilayer body in which a plurality of dielectric layers are layered, and the coil pattern (23) results from connecting a plurality of annular conductors (23a - 23f) arranged on the respective plurality of dielectric layers via interlayer conductors in the layered direction of the multilayer body in a helical pattern having the winding axis.

## Patentansprüche

1. Ein Drahtlose-Integrierte-Schaltung-Bauelement, das folgende Merkmale aufweist:
eine drahtlose integrierte Schaltung (5), die angeordnet ist, um ein Funksignal zu verarbeiten;
eine Leistungsversorgungsschaltungsplatine (4), die mit der drahtlosen integrierten Schaltung (5) verbunden ist und eine Leistungsversorgungsschaltung umfasst, die zumindest eine Spulenstruktur (23) umfasst; und
eine Strahlungsplatte (100; 110; 120; 130), die angeordnet ist, um ein Übertragungssignal, das von der drahtlosen integrierten Schaltung über die Leistungsversorgungsschaltungsplatine (4) zugeführt wird, auszustrahlen, und um durch die drahtlose integrierte Schaltung über die Leistungsversorgungsschaltungsplatine (4) ein Empfangssignal zu empfangen,
wobei die Strahlungsplatte (100; 110; 120; 130) eine erste Elektrode (101; 111; 121; 131) umfasst, die eine Öffnung (107; 117; 127; 137) umfasst, und eine ringförmige zweite Elektrode (108; 118; 128; 138), die die erste Elektrode (101; 111; 121; 131) umgibt, wobei die Strahlungsplatte (100; 110; 120; 130) zumindest eine Apertur (109; 119; 129; 139) aufweist, die durch die ringförmige zweite Elektrode umgeben ist, und einen Schlitz (106; 116; 126; 136), der mit der Öffnung (107; 117; 127; 137) verbunden ist,
wobei sich der Schlitz (106; 116; 126; 136) von der Öffnung zu einer Seitenkante der Strahlungsplatte (100; 110; 120; 130) oder zu der zumindest einen Apertur (129) erstreckt,
wobei, in einer Draufsicht von einer Wicklungsachsenrichtung der Spulenstruktur (23) aus gesehen, die Öffnung (107; 117; 127; 137) in der Strahlungsplatte (100; 110; 120; 130) mit zumindest einem Abschnitt eines inneren Bereichs der Spulenstruktur (23) überlappt, und
wobei, wenn ein Strom durch die Spulenstruktur (23) fließt, ein induziertes Magnetfeld einen induzierten Strom um die Öffnung (107; 117; 127; 137) in der Strahlungsplatte (100; 110; 120; 130) herum erregt,
**dadurch gekennzeichnet, dass** die Spulenstruktur (23) mit zumindest einem Abschnitt der Strahlungsplatte (100; 110; 120; 130) überlappt, der die Öffnung (107; 117; 127; 137) umgibt.

2. Das Drahtlose-Integrierte-Schaltung-Bauelement gemäß Anspruch 1, bei dem die Apertur (109; 119; 129; 139) einen ersten und einen zweiten Abschnitt aufweist, wobei die Öffnung (107; 117; 127; 137) zwischen dem ersten und zweiten Abschnitt der Apertur (109; 119; 129; 139) angeordnet ist.

3. Das Drahtlose-Integrierte-Schaltung-Bauelement gemäß Anspruch 2, bei dem sich der Schlitz (106; 116; 136) durch eine Region der Strahlungsplatte (100; 110; 130), die zwischen dem ersten und zweiten Abschnitt der Apertur (109; 119; 139) angeordnet ist, zu einer Kante der Strahlungsplatte (100; 110; 130) erstreckt.

4. Das Drahtlose-Integrierte-Schaltung-Bauelement gemäß Anspruch 1, das zwei Aperturen (119; 129; 139) aufweist, wobei die Öffnung (117; 127; 137) zwischen den Aperturen (119; 129; 139) angeordnet ist.

5. Das Drahtlose-Integrierte-Schaltung-Bauelement gemäß Anspruch 4, bei dem sich der Schlitz (116; 136) durch eine Region der Strahlungsplatte (110; 130), die zwischen den Aperturen (119; 139) angeordnet ist, zu einer Kante der Strahlungsplatte (110; 130) erstreckt.

6. Das Drahtlose-Integrierte-Schaltung-Bauelement gemäß Anspruch 4, bei dem sich der Schlitz (126) von der Öffnung (127) zu einer der Aperturen (129) erstreckt.

7. Das Drahtlose-Integrierte-Schaltung-Bauelement gemäß Anspruch 4 oder 5, bei dem die Strahlungsplatte (130) eine dritte Elektrode (138) aufweist, wobei die erste Elektrode (131) an der dritten Elektrode (138) haftet.

8. Das Drahtlose-Integrierte-Schaltung-Bauelement gemäß Anspruch 7, bei dem eine Öffnung und ein Schlitz in der dritten Elektrode (138) gebildet sind, unterhalb der Öffnung (137) und des Schlitzes (136) in der ersten Elektrode (131), und wobei die Öffnung und der Schlitz in der dritten Elektrode (138) größer sind als die Öffnung (137) und der Schlitz (136) in der ersten Elektrode (131).

9. Das Drahtlose-Integrierte-Schaltung-Bauelement gemäß einem der Ansprüche 1 bis 8, bei dem bei der Ausstrahlung des Übertragungssignals ein induzierter Strom um die Öffnung in der Strahlungsplatte (100; 110; 120; 130) herum erregt wird, durch einen Strom, der durch die Spulenstruktur (23) fließt, und ein Magnetfeld und ein elektrisches Feld, die durch den induzierten Strom verursacht werden, breiten sich über die Strahlungsplatte (100; 110; 120; 130) aus, um zu bewirken, dass die Strahlungsplatte (100; 110; 120; 130) als eine Elektrisches-Feld-Antenne arbeitet.

10. Das Drahtlose-Integrierte-Schaltung-Bauelement gemäß einem der Ansprüche 1 bis 9, bei dem in einer Draufsicht von der Wicklungsachsenrichtung der Spulenstruktur (23) aus gesehen die Öffnung in der Strahlungsplatte (100; 110; 120; 130) im Wesentlichen vollständig mit dem inneren Bereich der Spulenstruktur (23) überlappt und der Bereich der Öffnung etwa der gleiche ist wie derjenige des inneren Bereichs.

11. Das Drahtlose-Integrierte-Schaltung-Bauelement gemäß einem der Ansprüche 1 bis 10, bei dem die drahtlose integrierte Schaltung (5) von einem Chip-Typ ist und auf einer Hauptfläche der Leistungsversorgungsschaltungsplatine (4) installiert ist, und die Leistungsversorgungsschaltungsplatine (4) auf der Strahlungsplatte (100; 110; 120; 130) oder einer Tragebasis befestigt ist, die die Strahlungsplatte (100; 110; 120; 130) trägt, mit der anderen Hauptfläche der Leistungsversorgungsschaltungsplatine (4) als Befestigungsfläche.

12. Das Drahtlose-Integrierte-Schaltung-Bauelement gemäß Anspruch 11, bei dem eine Befestigungselektrode (12), die nicht direkt mit der Leistungsversorgungsschaltung verbunden ist, auf der anderen Hauptfläche der Leistungsversorgungsschaltungsplatine (4) vorgesehen ist, und die Befestigungselektrode (12) mit einer Befestigungselektrode (15) auf der Strahlungsplatte (100; 110; 120; 130) gekoppelt ist, die als Teil der Strahlungsplatte definiert ist oder die nicht direkt mit der Strahlungsplatte (100; 110; 120; 130) verbunden ist, über eine leitfähige Verbindung.

13. Das Drahtlose-Integrierte-Schaltung-Bauelement gemäß Anspruch 7, bei dem ein Hauptteil der Befestigungselektrode (12) auf der Leistungsversorgungsschaltungsplatine (4) in einem anderen Bereich als dem inneren Bereich der Spulenstruktur (23) vorgesehen ist.

14. Das Drahtlose-Integrierte-Schaltung-Bauelement gemäß einem der Ansprüche 1 bis 13, bei dem die Leistungsversorgungsschaltungsplatine (4) aus einem Mehrschichtkörper zusammengesetzt ist, in dem eine Mehrzahl von dielektrischen Schichten geschichtet ist, und die Spulenstruktur (23) sich ergibt aus dem Verbinden einer Mehrzahl von ringförmigen Leitern (23a - 23f), die auf der jeweiligen Mehrzahl von dielektrischen Schichten angeordnet ist, über Zwischenschichtleiter in der Schichtrichtung des Mehrschichtkörpers in einer Spiralstruktur mit der Wicklungsachse.

## Revendications

1. Dispositif de circuit intégré sans fil comprenant :
un circuit intégré sans fil (5) agencé pour traiter un signal radio ;
une carte de circuit imprimé d'alimentation électrique (4) raccordée au circuit intégré sans fin (5) et comprenant un circuit d'alimentation électrique comprenant au moins un modèle de bobine (23) ; et
une plaque de rayonnement (100 ; 110 ; 120 ; 130) agencée pour rayonner un signal de transmission fourni par le circuit intégré sans fil via la carte de circuit imprimé d'alimentation électrique (4) et pour recevoir un signal de réception par le circuit intégré sans fil via la carte de circuit imprimé d'alimentation électrique (4),
dans lequel la plaque de rayonnement (100 ; 110 ; 120 ; 130) comprend une première électrode (101 ; 111 ; 121 ; 131) comprenant une ouverture (107 ; 117 ; 127 ; 137) et une deuxième électrode annulaire (108 ; 118 ; 128 ; 138) entourant la première électrode (101 ; 111 ; 121 ; 131), dans lequel la plaque de rayonnement (100 ; 110 ; 120 ; 130) comprend au moins un orifice (109 ; 119 ; 129 ; 139) entouré par la deuxième électrode annulaire et une fente (106 ; 116 ; 126 ; 136) raccordée à l'ouverture (107 ; 117 ; 127 ; 137),
dans lequel la fente (106 ; 116 ; 126 ; 136) s'étend à partir de l'ouverture vers un bord latéral de la plaque de rayonnement (100 ; 110 ; 120 ; 130) ou vers la au moins une ouverture (129),
dans lequel, lorsqu'elle est observée en plan à partir d'une direction d'un axe d'enroulement du modèle de bobine (23), l'ouverture (107 ; 117 ; 127 ; 137) dans la plaque de rayonnement (100 ; 110 ; 120 ; 130) chevauche au moins une partie d'une zone interne du modèle de bobine (23), et
dans lequel, lorsqu'un courant s'écoule par le modèle de bobine (23), un champ magnétique induit excite un courant induit autour de l'ouverture (107 ; 117 ; 127 ; 137) dans la plaque de rayonnement (100 ; 110 ; 120 ; 130),
**caractérisé en ce que** le modèle de bobine (23) recouvre au moins une partie de la plaque de rayonnement (100 ; 110 ; 120 ; 130) entourant l'ouverture (107 ; 117 ; 127 ; 137).

2. Dispositif de circuit intégré sans fil selon la revendication 1, dans lequel l'orifice (109 ; 119 ; 129 ; 139) comprend des première et seconde parties, dans lequel l'ouverture (107 ; 117 ; 127 ; 137) est agencée entre les première et seconde parties de l'orifice (109 ; 119 ; 129 ; 139) .

3. Dispositif de circuit intégré sans fil selon la revendication 2, dans lequel la fente (106 ; 116 ; 136) s'étend à travers une région de la plaque de rayonnement (100 ; 110 ; 130) agencée entre les première et seconde parties de l'orifice (109 ; 119 ; 139) jusqu'à un bord de la plaque de rayonnement (100 ; 110 ; 130).

4. Dispositif de circuit intégré sans fil selon la revendication 1, comprenant deux orifices (119 ; 129 ; 139), dans lequel l'ouverture (117 ; 127 ; 137) est agencée entre les orifices (119 ; 129 ; 139).

5. Dispositif de circuit intégré sans fil selon la revendication 4, dans lequel la fente (116 ; 136) s'étend à travers une région de la plaque de rayonnement (110 ; 130) agencée entre les orifices (119 ; 139) jusqu'à un bord de la plaque de rayonnement (110 ; 130).

6. Dispositif de circuit intégré sans fil selon la revendication 4, dans lequel la fente (126) s'étend à partir de l'ouverture (127) jusqu'à l'un des orifices (129).

7. Dispositif de circuit intégré sans fil selon la revendication 4 ou 5, dans lequel la plaque de rayonnement (130) comprend une troisième électrode (138), dans lequel la première électrode (131) est collée à la troisième électrode (138) .

8. Dispositif de circuit intégré sans fil selon la revendication 7, dans lequel une ouverture et une fente sont formées dans la troisième électrode (138) disposée au-dessous de l'ouverture (137) et de la fente (136) dans la première électrode (131) et, dans lequel l'ouverture et la fente dans la troisième électrode (138) sont plus grandes que l'ouverture (137) et la fente (136) dans la première électrode (131).

9. Dispositif de circuit intégré sans fil selon l'une des revendication 1 à 8,
dans lequel, dans le rayonnement du signal de transmission, un courant induit est excité autour de l'ouverture dans la plaque de rayonnement (100 ; 110 ; 120 ; 130) par un courant s'écoulant à travers le modèle de bobine (23) et un champ magnétique et un champ électrique provoqué par le courant induit, s'étalent sur la plaque de rayonnement (100 ; 110 ; 120 ; 130) pour amener la plaque de rayonnement (100 ; 110 ; 120 ; 130) à fonctionner comme une antenne à champ électrique.

10. Dispositif de circuit intégré sans fil selon l'une quelconque des revendications 1 à 9,
dans lequel, observé en plan à partir de la direction de l'axe d'enroulement du modèle de bobine (23), l'ouverture dans la plaque de rayonnement (100 ; 110 ; 120 ; 130) est sensiblement entièrement recouverte avec la surface interne du modèle de bobine (23) et la surface de l'ouverture est approximativement identique à celle de la surface interne.

11. Dispositif de circuit intégré sans fil selon l'une quelconque des revendications 1 à 10,
dans lequel le circuit intégré sans fil (5) est du type à puce et est installé sur une face principale de la carte de circuit imprimé d'alimentation électrique (4), et la carte de circuit imprimé d'alimentation électrique (4) est montée sur la plaque de rayonnement (100 ; 110 ; 120 ; 130) ou une base de support supportant la plaque de rayonnement (100 ; 110 ; 120 ; 130) avec l'autre face principale de la carte de circuit imprimé d'alimentation électrique (4) en tant que face de montage.

12. Dispositif de circuit intégré sans fil selon la revendication 11,
dans lequel une électrode de montage (12) qui n'est pas directement raccordée au circuit d'alimentation électrique est prévue sur l'autre face principale de la carte de circuit imprimé d'alimentation électrique (4), et l'électrode de montage (12) est couplée à une électrode de montage (15) sur la plaque de rayonnement (100 ; 110 ; 120 ; 130) qui est définie comme faisant partie de la plaque de rayonnement ou qui n'est pas directement raccordée à la plaque de rayonnement (100 ; 110 ; 120 ; 130) via une liaison conductrice.

13. Dispositif de circuit intégré sans fil selon la revendication 7,
dans lequel une partie principale de l'électrode de montage (12) sur la carte de circuit imprimé d'alimentation électrique (4) est prévue dans une autre surface que la surface interne du modèle de bobine (23).

14. Dispositif de circuit intégré sans fil selon l'une quelconque des revendications 1 à 13,
dans lequel la carte de circuit imprimé d'alimentation électrique (4) est composée d'un corps à plusieurs couches dans lequel une pluralité de couches diélectriques sont déposées en couche, et le modèle de bobine (23) provient du raccordement d'une pluralité de conducteurs annulaires (23a - 23f) agencés sur la pluralité respective de couches diélectriques via des conducteurs entre les couches dans le sens des couches du corps à plusieurs couches selon un modèle hélicoïdal ayant l'axe d'enroulement.
